# EUROPEAN PATENT APPLICATION

(11) **EP 4 757 113 A1**
(43) Date of publication of application: **10.06.2026**
(21) Application number: 25220498.7
(22) Date of filing: 03.12.2025
(51) Int. Cl.: H02J 7/34, H01M 10/48, H02J 7/36, H02J 7/50, H02J 7/60, H02J 7/80, H02J 7/90

(54) **ELECTRICAL POWER SYSTEM AND MANAGEMENT METHOD**

(30) Priority: 06.12.2024 US 202418972121
(71) Applicant: The Boeing Company, Arlington, VA 22202 (US)
(72) Inventor: BERON-RAWDON, DEBORAH A., Arlington, 22202 (US); ATMUR, ROBERT J., Arlington, 22202 (US)
(74) Representative: Sandri, Sandro

(57) **Abstract**

An electrical power system includes a battery system that includes multiple battery modules, and an electrical distribution network. The battery system further includes, for each battery module of the battery system, a respective module interface device having a switching circuit that is operable to connect and disconnect that battery module with respect to the electrical distribution network independent of other battery modules of the battery system. The electrical power system further includes a control system operatively coupled to each module interface device. The control system is configured to command the module interface devices of a first subset of battery modules to connect the first subset of battery modules to the electrical distribution network, and to command the module interface devices of a second subset of battery modules to disconnect the battery modules of the second subset from electrical distribution network.

## Description

### FIELD

A disclosed invention relates generally to managing operation of electrical power systems that include multiple battery modules.

### BACKGROUND

Battery systems can incorporate multiple battery modules to provide an overall battery function and performance with respect to an electrical load or an electrical source. Multi-module battery systems can present significant challenges with respect to controlling, using, and determining the health and performance of individual battery modules. Such challenges can be more significant in use case scenarios where battery modules of the battery system exhibit different or unknown performance capabilities. For example, used batteries of unknown health and performance capabilities can cause failures or damage to a battery system and associated equipment, or can cause degraded operation of the battery system and an electrical load or an electrical source that is connected to the battery system.

### SUMMARY

In an example, an electrical power system includes a battery system that includes multiple battery modules, and an electrical distribution network for the battery system that includes a cathode-side interface and an anode-side interface. The electrical power system further includes, for each battery module of the battery system, a respective module interface device that includes a measurement circuit operable to measure one or more performance parameters of that battery module, and a switching circuit operable to connect and disconnect that battery module with respect to the electrical distribution network independent of other battery modules of the battery system. The electrical power system further includes a control system operatively coupled to each module interface device.

The control system is configured to obtain a target value of a performance parameter for the battery system. For each battery module of the battery system, the control system is configured to obtain a module-specific measurement of the performance parameter via the measurement circuit of the module interface device of that battery module. The control system is configured to select a first subset of battery modules of the battery system to be connected to the electrical distribution network based on the target value of the performance parameter and the module-specific measurement of the performance parameter obtained for each battery module of at least the first subset of battery modules.

The control system is configured to, for each battery module of the first subset, command the module interface device of that battery module to connect that battery module to the electrical distribution network via the switching circuit of the module interface device. The control system is configured to, for each battery module of a second subset of battery modules of the battery system not included in the first subset, command the module interface device of that battery module to disconnect that battery module from electrical distribution network via the switching circuit of the module interface device.

### BRIEF DESCRIPTION OF THE DRAWINGS

FIG. 1 is a schematic diagram depicting an example electrical power system.
FIG. 2 is a schematic diagram depicting additional aspects of a portion of the electrical power system of FIG. 1.
FIG. 3 is a schematic diagram depicting additional aspects of an example module interface device of an example battery module.
FIGS. 4A, 4B, 4C, and 4D are flow diagrams depicting an example method of managing operation of an electrical power system.
FIG. 5 is a schematic diagram depicted an example computing system that can form part of a control system of FIG. 1.

### DETAILED DESCRIPTION

Growth in the use of battery powered electric vehicles and other battery powered devices may result in an increase the available supply of used batteries that potentially can be reused prior to their eventual recycling or disposal. Battery reuse offers the potential to extend the useful life of batteries, and to delay or even avoid the need to recycle or dispose of such batteries. Secondary use markets for used batteries may exist, including as alternative energy storage systems for micro and mega electrical power systems, as an example. Energy gathering systems that could benefit from the reuse of batteries include wind, solar, hydro, wave and tidal power, as examples.

Multi-module battery systems can present significant challenges with respect to controlling, using, and determining the health and performance of individual battery modules. Such challenges can be more significant in use case scenarios where battery modules of the battery system exhibit different or unknown health and performance capabilities. For example, used batteries of unknown health and performance capabilities can cause failures or damage to a battery system and associated equipment, or can cause degraded operation of the battery system and an electrical load or an electrical source that is connected to the battery system.

An electrical power system and a method for managing operation of the electrical power system are disclosed herein that offers the potential to successfully reuse end-of-life batteries. The electrical power system features module interface devices that are operable to independently isolate individual battery modules within a battery system, and to independently measure performance parameters of the individual battery modules. Accordingly, battery modules of unknown and diverse health and performance capabilities can be measured and isolated within the context of a multi-module battery system, thereby potentially enabling successful reuse of end-of-life battery modules. The electrical power system and associated method of battery system management enables operators to construct appropriate voltage and current handling of battery installations without physical disassembly of the end-of-life batteries, thereby potentially extending the utility of a battery system until the last battery module of the system fails.

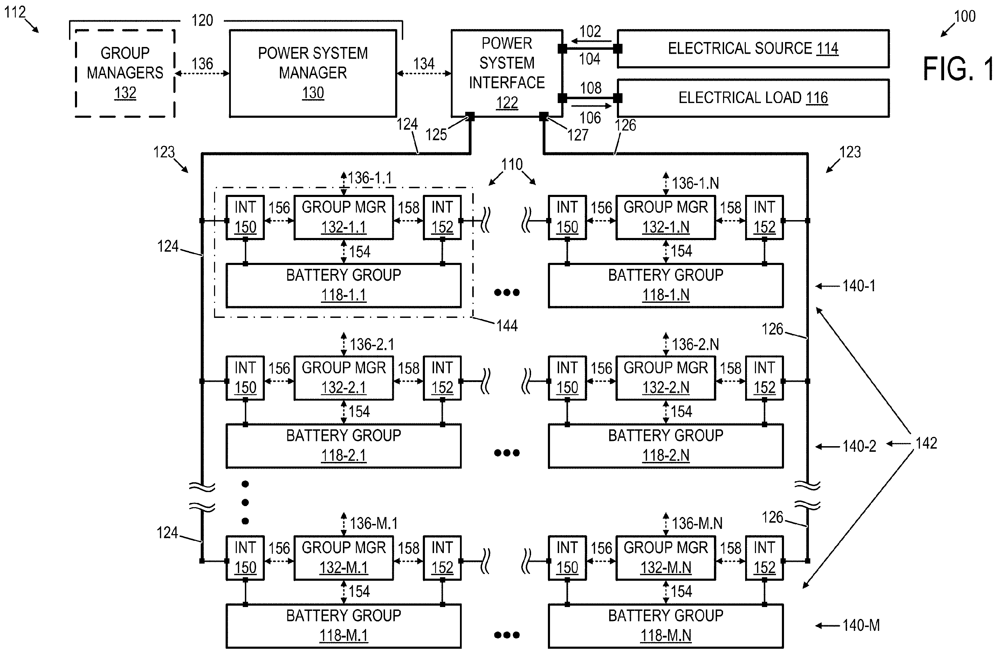

FIG. 1 is a schematic diagram depicting an example electrical power system 100 that includes a battery system 110 and a battery management system 112 for managing operation of the battery system. Electrical power system 100 can include or interface with an electrical source 114 and an electrical load 116, depicted schematically in FIG. 1.

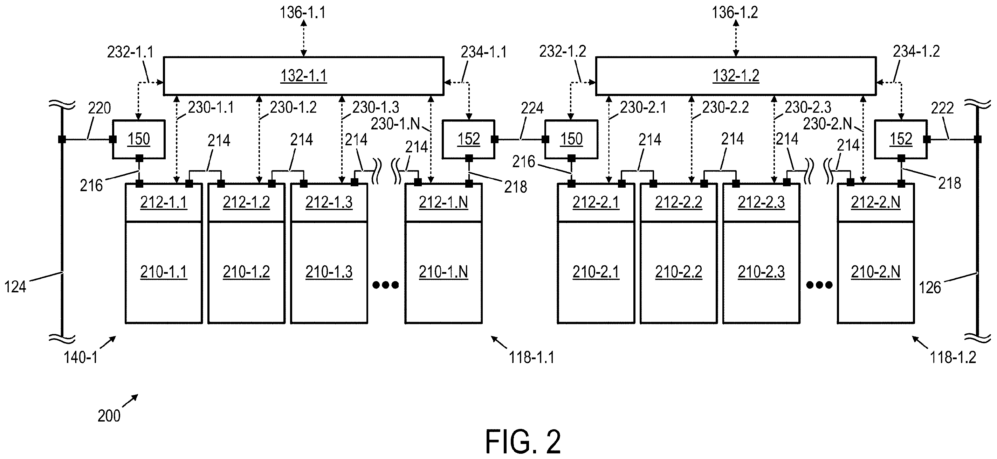

Battery system 110 includes multiple battery groups identified in FIG. 1 by reference numeral 118. Each battery group identified by reference numeral 118 can include one or more battery modules, as described in further detail with reference to FIG. 2. The battery groups of battery system 110 can be interconnected with each other by an electrical distribution network of power system 100 that includes various electrical pathways, including a cathode-side electrical pathway 124 and an anode-side electrical pathway 126. Electrical distribution system 123 can include additional components that interconnect battery groups and battery modules thereof, as described in further detail with reference to FIG. 2.

Battery management system 112 includes a control system 120 that is operable to control operation of battery system 110 and other components of the battery management system, as described herein. As an example, battery management system 112 can store electrical energy 102 at battery system 110 that is received from electrical source 114 via one or more electrical pathways 104. In this example, power system 100 can include a power system interface 122 that is operable by control system 120 to direct electrical energy 102 received from electrical source 114 via electrical pathways 104 to battery system 110 for storage via electrical distribution system 123. In the example of FIG. 1, power system interface 122 is electrically coupled with battery system 110 via cathode-side electrical pathway 124 and anode-side electrical pathway 126 of electrical distribution network 123. Cathode-side electrical pathway 124 includes a cathode-side interface 125 of electrical distribution network 123, anode-side electrical pathway 126 includes an anode-side interface 127 of the electrical distribution network.

As another example, battery management system 112 can supply electrical energy 106 stored at battery system 110 to electrical load 114 via power system interface 122 over one or more electrical pathways 108. In this example, power system interface 122 is operable by control system 120 to direct electrical energy 106 that is supplied by battery system 110 via electrical pathways 124 and 126 of electrical distribution system 123 to electrical load 116 via electrical pathways 108.

In the example of FIG. 1, control system 120 includes a power system manager 130 and group managers identified by reference numeral 132 for each respective battery group identified by reference numeral 118. Power system manager 130 can control operation of power system interface 122 via one or more communications links 134, which can include wired and/or wireless communications links. Furthermore, power system manager 130 can control operation of group managers identified by reference numeral 132 via communications links 136, which can include one or more wired and/or wireless communications links.

Battery groups of battery system 110 can be arranged in a series configuration and/or a parallel configuration. For example, battery system 110 can include battery group 118-1.1 through battery group 118-1.N arranged in a first series configuration 140-1 between cathode-side electrical pathway 124 and anode-side electrical pathway 126, where the term "N" of identifier "1.N" can refer to any suitable quantity of battery groups of first series configuration 140-1. As an example, the term "N" of identifier "1.N" can refer to multiple battery groups of first series configuration 140-1. For example, first series configuration 140-1 can include two, three, four, five or more, 10 or more, 20 or more, etc. battery groups. As another example, first series configuration 140-1 can include a single battery group represented in FIG. 1 as battery group 118-1.1.

Furthermore, in this example, battery system 110 can include battery group 118-2.1 through battery group 118-2.N arranged in a second series configuration 140-2 between cathode-side electrical pathway 124 and anode-side electrical pathway 126, where the term "N" of identifier "2.N" can refer to any suitable quantity of battery groups of second series configuration 140-2. As an example, the term "N" of identifier "2.N" can refer to multiple battery groups of second series configuration 140-2. For example, second series configuration 140-2 can include two, three, four, five or more, 10 or more, 20 or more, etc. battery groups. As another example, second series configuration 140-2 can include a single battery group represented in FIG. 1 as battery group 118-2.1. It will be understood that the quantity of battery groups of second series configuration 140-2 can be the same as or differ from the quantity of battery groups of first series configuration 140-1. For example, second series configuration 140-2 can include a greater or less quantity of battery groups as compared to first series configuration 140-1.

Furthermore, in this example, battery system 110 can include battery group 118-M.1 through battery group 118-M.N arranged in an Mth series configuration 140-M between cathode-side electrical pathway 124 and anode-side electrical pathway 126, where the term "N" of identifier "M.N" can refer to any suitable quantity of battery groups of Mth series configuration 140-M. As an example, the term "N" of identifier "M.N" can refer to multiple battery groups of Mth series configuration 140-M. For example, Mth series configuration 140-M can include two, three, four, five or more, 10 or more, 20 or more, etc. battery groups. As another example, Mth series configuration 140-M can include a single battery group represented in FIG. 1 as battery group 118-M.1. Again, it will be understood that the quantity of battery groups of Mth series configuration 140-M can be the same as or differ from the quantity of battery groups of first series configuration 140-1 and second series configuration 140-2.

Additionally, in this example, first series configuration 140-1 of battery group 118-1.1 through battery group 118-1.N, second series configuration 140-2 of battery group 118-2.1 through battery group 118-2.N, and Mth series configuration 140-M of battery group 118-M.1 through battery group 118-M.N are arranged in a parallel configuration 142 between cathode-side electrical pathway 124 and anode-side electrical pathway 126, where the term "M" of identifier "M.N" can refer to any suitable quantity of series configurations of battery groups arranged in parallel configuration 140-M.

In some examples, battery system 110 can include a single series configuration of one or more battery groups, identified in FIG. 1 as first series configuration 140-1. In this example, second series configuration 140-2 and Mth series configuration 140-M can be omitted. Additionally, in this example, parallel configuration 142 is not present as battery system 110 includes a single series configuration of battery groups (e.g., 140-1).

Each battery group of battery system 110 can be associated with a respective group manager, a cathode-side interface device 150, and an anode-side interface 152 of that battery group. For example, battery group 118-1.1 is associated with group manager 132-1.1, a cathode-side interface device 150, and an anode-side interface 152. Collectively, each battery group and the respective group manager, cathode-side interface device 150, and anode-side interface 152 that are associated with that battery group form a modular unit 144. An example of an instance of modular unit 144 is depicted in FIG. 1 with respect to battery group 118-1.1.

Operation of each battery group of battery system 110 can be managed, at least in part, by a respective group manager of its modular unit 144. As an example operation of battery group 118-1.1 can be managed, at least in part, by group manager 132-1.1. Each group manager can communicate and selectively exchange electrical energy with its respective battery group via one or more electrical links 154, which can include one or more communications links and one or more electrical pathways, as described in further detail herein with reference to FIG. 2. As additional examples, operation of battery group 118-1.N can be managed, at least in part, by group manager 132-1.N, operation of battery group 118-2.1 can be managed, at least in part, by group manager 132-2.1, operation of battery group 118-1.N can be managed, at least in part, by group manager 132-1.N, operation of battery group 118-M.1 can be managed, at least in part, by group manager 132-M.1, and operation of battery group 118-M.N can be managed, at least in part, by group manager 132-M.N.

Power system manager 130 can be operatively coupled to each group manager via one or more electrical links identified by reference numeral 136 in FIG. 1 coordinate operation of the battery groups of battery system 110, which can include one or more communications links and one or more electrical pathways, as described in further detail herein with reference to FIG. 2. As examples, power system manager 130 is operatively coupled to group manager 132-1.1 via electrical links 136-1.1, to group manager 132-1.N via electrical links 136-1.N, to group manager 132-2.1 via electrical links 136-2.1, to group manager 132-2.N via electrical links 136-2.N, to group manager 132-M.1 via electrical links 136-M.1, and to group manager 132-M.N via electrical links 136-M.N.

Additionally, each group manager can manage operation of its associated cathode-side interface device 150 and anode-side interface 152 of its modular unit 144. For example, each group manager can communicate with its respective cathode-side interface device 150 via one or more communications links 156, and can communicate with its respective anode-side interface 152 via one or more communications links 158. Communications links 156 and 158 can each include wired and/or wireless communications links.

Within each series configuration of battery groups (e.g., 140-1 through 140-M), a first battery group of that series configuration is electrically coupled to cathode-side electrical pathway 124 via cathode-side interface device 150 of its modular unit 144, and a last battery group of that series configuration is electrically coupled to anode-side interface pathway 126 via anode-side interface 152 of its modular unit 144. Within each series configuration of battery groups (e.g., 140-1 through 140-M) that includes multiple battery groups, each neighboring pair of battery groups are electrically coupled to each other via anode-side interface 152 and cathode-side interface device 154, as described in further detail with reference to FIG. 2.

FIG. 2 is a schematic diagram depicting an example portion 200 of power system 100 of FIG. 1 in further detail. Portion 200 includes an example of first series configuration 140-1 of FIG. 1, which includes two battery groups - battery group 118-1.1 and battery group 118-1.2. In this example, battery group 118-1.2 is an example of battery group 118-1.N of FIG. 1 in which the term "N" refers to the second battery group of series configuration 140-1.

Battery group 118-1.1 includes multiple battery modules, which in this example includes battery modules 210-1.1, 210-1.2, 210-1.3 through 210-1.N, where the term "N" of identifier "1.N" can refer to any suitable quantity of battery modules of battery group 118-1.1. Battery group 118-1.2 includes multiple battery modules, which in this example includes battery modules 210-2.1, 210-2.2, 210-2.3 through 210-2.N, where the term "N" of identifier "2.N" can refer to any suitable quantity of battery modules of battery group 118-2.1. Battery group 118-2.1 can have the same or a different quantity of battery modules as battery group 118-1.1. The total quantity of battery modules of a series configuration of battery groups, such as series configuration 140-1, can be selected to provide a target electrical voltage or at least a target electrical voltage between cathode-side electrical pathway 124 and anode-side electrical pathway 126 of electrical distribution network 123 of FIG. 1 for a given battery module voltage or set of battery module voltages.

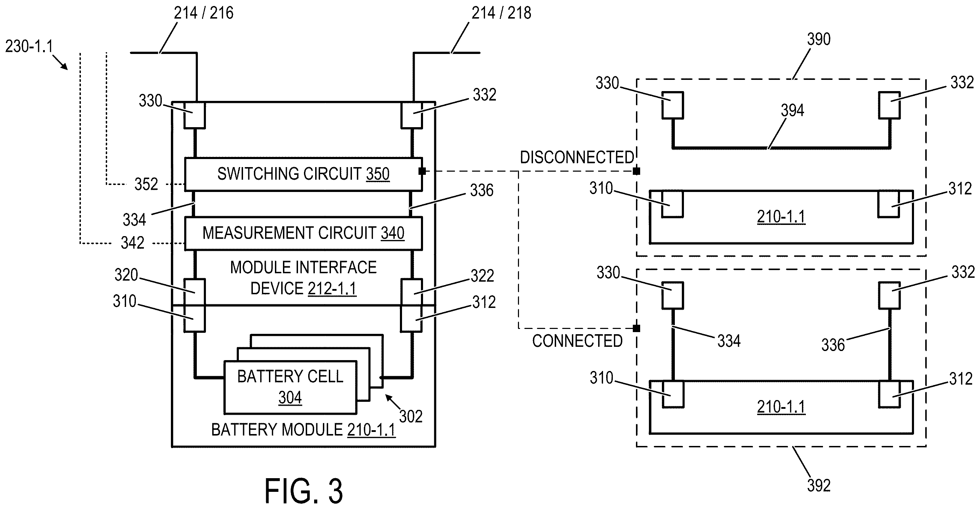

For each battery module of the battery system, a respective module interface device identified by reference numeral 212 is electrically coupled to cathode and anode terminals of that battery module, as described in further detail with reference to FIG. 3. The module interface devices described herein form part of battery management system 112 of FIG. 1. For example, with respect to battery group 118-1.1, module interface device 212-1.1 is electrically coupled to battery module 210-1.1, module interface device 212-1.2 is electrically coupled to battery module 210-1.2, module interface device 212-1.3 is electrically coupled to battery module 210-1.3, and module interface device 212-1.N is electrically coupled to battery module 210-1.N. Similarly, with respect to battery group 118-1.2, module interface device 212-2.1 is electrically coupled to battery module 210-2.1, module interface device 212-2.2 is electrically coupled to battery module 210-2.2, module interface device 212-2.3 is electrically coupled to battery module 210-2.3, and module interface device 212-2.N is electrically coupled to battery module 210-2.N.

Module interface devices of each battery group can be electrically coupled to each other in series by inter-module interconnects 214, as described in further detail with reference to FIG. 3. A first module interface device on a cathode side of each battery group can be electrically coupled to cathode-side interface device 150 by a cathode-side interconnect 216, and a last module interface device on an anode side of each battery group can be electrically coupled to anode-side interface device 152 by an anode-side interconnect 218. Cathode-side interface device 150 of the first battery group (e.g., 118-1.1) of series configuration 140-1 can be electrically coupled to cathode-side electrical pathway 124 by a cathode-side interconnect 220, and a last battery group (e.g., 118-1.2) of series configuration 140-1 can be electrically coupled to anode-side electrical pathway 126 by an anode-side interconnect 222. Between two battery groups of series configuration 140-1, anode-side interface device 152 of a first battery group (e.g., 118-1.1) can be electrically coupled to cathode-side interface device 150 of a second battery group (e.g., 118-1.2) by an inter-group interconnect 224.

Each group manager is operatively coupled to the module interface devices of its corresponding battery group via a set of one or more electrical connections identified by reference numeral 230 in FIG. 2. As described in further detail herein, each module interface device can include a switching circuit and a measurement circuit that are operable by the group manager of that module interface device via the set of electrical connections 230. Each group manager can command the switching circuit of a module interface device of its battery group via the set of electrical connections 230 to the module interface device to connect or disconnect the battery module of the module interface device with respect to the electrical distribution network 123 of FIG. 1. Additionally, each group manager can command the measurement circuit of a module interface device of its battery group via the set of electrical connections 230 to the module interface device to measure one or more performance parameters of the battery module of the module interface device,

For example, in FIG. 2 group manager 132-1.1 is operatively coupled to module interface device 212-1.1 by a set of electrical connections 230-1.1, to module interface device 212-1.2 by a set of electrical connections 230-1.2, to module interface device 212-1.3 by a set of electrical connections 230-1.3, and to module interface device 212-1.N by a set of electrical connections 230-1.N. Similarly, group manager 132-1.2 is operatively coupled to module interface device 212-2.1 by a set of electrical connections 230-2.1, to module interface device 212-2.2 by a set of electrical connections 230-2.2, to module interface device 212-2.3 by a set of electrical connections 230-2.3, and to module interface device 212-2.N by a set of electrical connections 230-2.N.

Additionally, each group manager is operatively coupled to cathode-side interface device 150 of its corresponding battery group via a set of one or more electrical connections identified by reference numeral 232. For example, group manager 132-1.1 is operatively coupled to cathode-side interface device 150 of battery group 118-1.1 via a set of electrical connections 232-1.1, and group manager 132-1.2 is operatively coupled to cathode-side interface device 150 of battery group 118-1.2 via a set of electrical connections 232-1.2. Cathode-side interface device 150 can include a switch that is operable to connect and disconnect the battery group with respect to electrical distribution network 123 of FIG. 1. For example, each group manager can command cathode-side interface device 150 of its corresponding battery group via the set of electrical connections 232 to connect or disconnect the battery group with respect to the electrical distribution system between cathode side interconnect 216 and either cathode-side interconnect 220 or inter-group interconnect 224.

Additionally, each group manager is operatively coupled to anode-side interface device 152 of its corresponding battery group via a set of one or more electrical connections identified by reference numeral 234. For example, group manager 132-1.1 is operatively coupled to anode-side interface device 152 of battery group 118-1.1 via a set of electrical connections 234-1.1, and group manager 132-1.2 is operatively coupled to anode-side interface device 152 of battery group 118-1.2 via a set of electrical connections 234-1.2. Anode-side interface device 152 can include a switch that is operable to connect and disconnect the battery group with respect to electrical distribution network 123 of FIG. 1. For example, each group manager can command anode-side interface device 152 of its corresponding battery group via the set of electrical connections 234 to disconnect or disconnect the battery group with respect to the electrical distribution system between anode-side interconnect 218 and either anode-side interconnect 222 or inter-group interconnect 224.

FIG. 3 is a schematic diagram depicting additional aspects of the module interfaces devices and battery modules of FIGS. 1 and 2, as described with reference to module interface device 212-1.1 that is electrically coupled to battery module 210-1.1.

As depicted schematically in FIG. 3 with reference to battery module 210-1.1, each battery module includes a set of one or more battery cells 302 in which an example battery cell 304 is depicted schematically in FIG. 3. Each battery module includes a cathode terminal 310 and an anode terminal 312.

Each module interface device includes a battery-side cathode interface 320 and a battery-side anode interface 322, as depicted schematically in FIG. 3 with reference to module interface device 212-1.1. The module interface device is electrically coupled to cathode terminal 310 of the battery module via battery-side cathode interface 320. The module interface device is electrically coupled to anode terminal 312 of the battery module via battery-side anode interface 322.

Each module interface device further includes a system-side cathode interface 330 and a system-side anode interface 332. System-side cathode interface 330 is electrically coupled to module-side cathode terminal 320, for example, by a cathode bus 334 of the module interface device. System-side cathode interface 330 of the module interface device is electrically coupled to either inter-module interconnect 214 or to cathode-side interconnect 216, as previously described with reference to FIG. 2. System-side anode interface 332 is electrically coupled to module-side anode terminal 322, for example, by an anode bus 336 of the module interface device. System-side anode interface 332 of the module interface device is electrically coupled to either inter-module interconnect 214 or to anode-side interconnect 218, as previously described with reference to FIG. 2.

Each module interface device further includes a measurement circuit 340 and a switching circuit 350. Measurement circuit 340 is operable by control system 120 of FIG. 1 to independently obtain module-specific measurements of performance parameters of the battery module to which the module interface device is electrically coupled. For example, measurement circuit 340 is electrically coupled between cathode bus 334 and anode bus 336, thereby enabling the measurement circuit to measure performance parameters of the battery module between the cathode terminal 310 and the anode terminal 312. In some examples, measurement circuit 340 can include one or more electrical components (e.g., a resistor) that exhibits a resistance across which performance parameters of the battery module can be measured. Examples of module-specific performance parameters that can be measured by measurement circuit 340 with respect to the battery module include a stored energy, an energy storage capacity, an electrical voltage, an electrical current, an electrical power. As an example, a group manager (e.g., 212-1.1 of FIG. 2) is operatively coupled to module interface device 212-1.1 via one or more electrical connections 342 of the set of electrical connections 230-1.1 by which the group manager can command measurement circuit 340 of the module interface device to obtain module-specific measurements of the performance parameters. Performance parameters of the battery module that are measured by measurement circuit 340 can be obtained by the group manager via the one or more electrical connections 342. Such measurements can be obtained by power system manager 130 of control system 120 via communications links 136. Alternatively or additionally, communications links 136 in this example can take the form of electrical pathways that enable power system manager 130 to measure or obtain measurements of performance parameters of the battery modules.

Switching circuit 350 is operable by control system 120 of FIG. 1 to independently connect and disconnect the battery module from electrical distribution network 123 of FIG. 1. As an example, a group manager (e.g., 212-1.1 of FIG. 2) is operatively coupled to module interface device 212-1.1 via one or more electrical connections 352 of the set of electrical connections 230-1.1 by which the group manager can command switching circuit 350 of the module interface device to connect or disconnect the battery module from the electrical distribution network. For example, switching circuit 350 is located along cathode bus 334 between module-side cathode terminal 310 and system-side cathode terminal 330. Switching circuit 350 can open and close a switch of the cathode bus to connect and disconnect the module-side cathode terminal with respect to the system-side cathode terminal. Additionally or alternatively, switching circuit 350 is located along anode bus 336 between module-side anode terminal 312 and system-side anode terminal 332, and switching circuit 350 can open and close a switch of the anode bus to connect and disconnect the module-side anode terminal with respect to the system-side anode terminal.

In FIG. 3, an example electrical pathway configuration 390 of module interface device 212-1.1 is schematically depicted when switching circuit 350 is operated to disconnect battery module 210-1.1 from electrical distribution network 123 of FIG. 1, and an example electrical pathway configuration 392 of module interface device 212-1.1 is schematically depicted when switching circuit 350 is operated to connected battery module 210-1.1 to electrical distribution network 123. When battery module 210-1.1 is disconnected from electrical distribution network 123, electrical pathway configuration 390 can include or utilize an electrical pathway 394 between system-side cathode interface 330 and system-side anode interface 332 that bypasses battery module 210-1.1. As schematically depicted with respect to electrical pathway configuration 390, electrical pathway 394 can enable other battery modules of the battery group containing battery module 210-1.1 to be electrically connected to each other and electrical distribution network 123 across module interface device 212-1.1 while battery module 210-1.1 is disconnected from electrical distribution network 123 and the other battery modules of the battery group. When battery module 210-1.1 is connected to electrical distribution network 123, electrical pathway configuration 392 can include or utilize cathode bus 334 that electrically connects system-side cathode interface 330 to cathode terminal 310, and anode bus 336 that electrically connects system-side anode interface 332 to anode terminal 312.

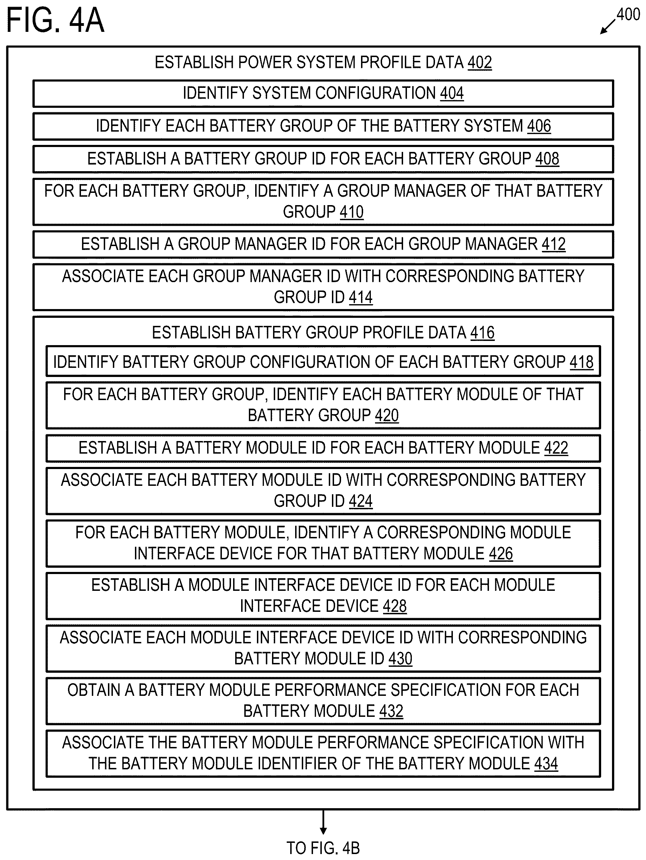

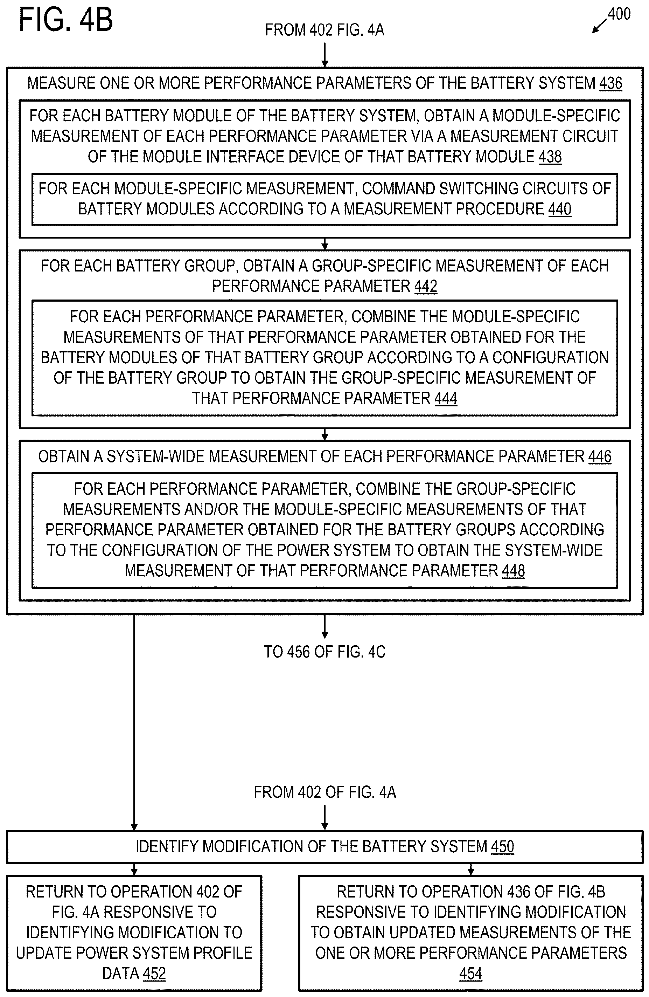

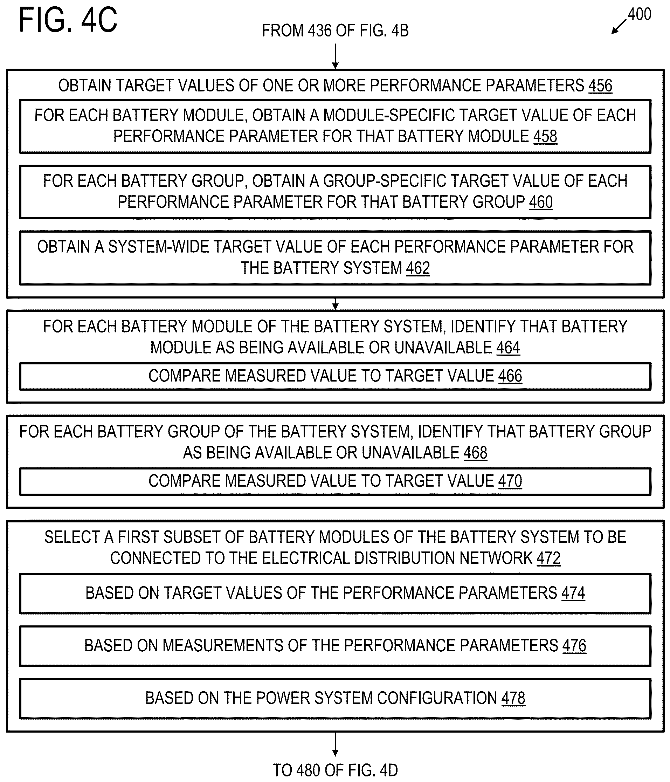

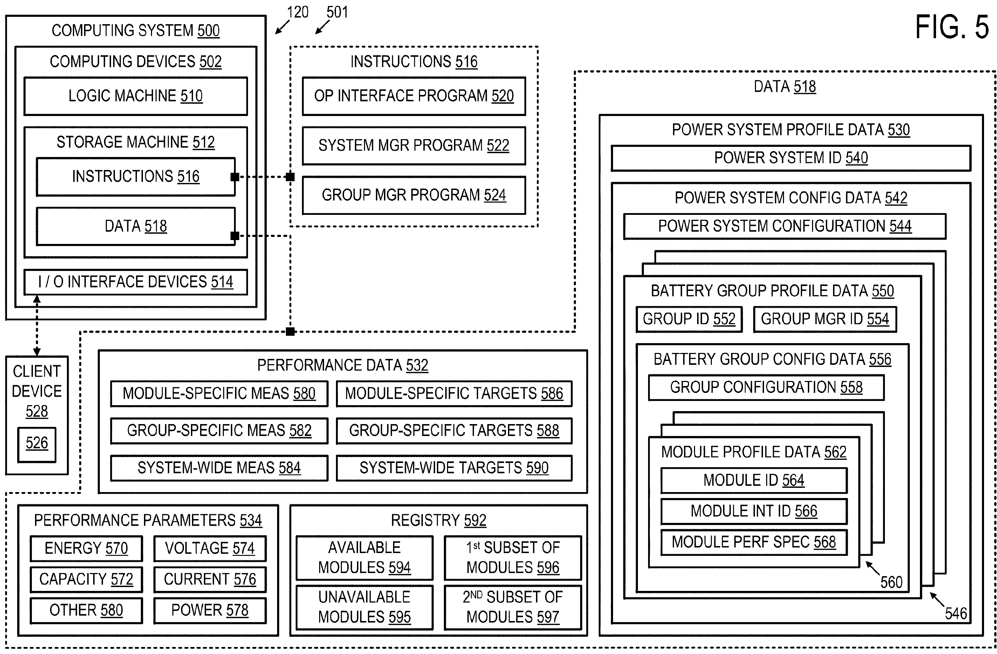

FIGS. 4A, 4B, and 4C are flow diagrams depicting an example method 400 of managing operation of an electrical power system, such as electrical power system 100 of FIG. 1. As an example, method 400 and various operations of the method can be performed by control system 120 of FIG. 1 or a computing system of one or more computing devices that form part of control system 120, as described in further detail with reference to FIG. 5.

Referring to FIG. 4A, at 402, the method can include establishing power system profile data for the power system. As described in further detail with reference to FIG. 5, power system profile data established at 402 can be stored at a data storage machine that can be accessed by control system 120 of FIG. 1. As part of establishing the power system profile data at 402, the method can include performing operations 404 through 434 of FIG. 4A.

At 404, the method can include identifying a system configuration of the electrical power system, including the battery system (e.g., 110 of FIG. 1) and components thereof, the battery management system (e.g., 112 of FIG. 1) and components thereof, and the electrical distribution system (e.g., 123 of FIG. 1) and components thereof. As an example, series configurations (e.g., 140-1 through 140-M) of battery groups, parallel configurations (e.g., 142) of battery groups, electrical interconnects between battery groups and battery modules, cathode-side electrical pathway 124, cathode-side interface 125, anode-side electrical pathway 126, and anode-side interface 127 can be identified.

In some examples, the system configuration identified at 404 can include a data representation of a nodal network of the electrical power system in which nodes represent components that include battery groups, battery modules, and interfaces 125, 127, 150, and 152; and electrical pathways of electrical distribution network 123 are represented by interconnections between or among the nodes. Additionally, the system configuration identified at 404 can include a data representation of a nodal network of logical components in which nodes represent components of battery management system 112, including module interface devices, battery group managers 132, interfaces 150 and 152, power system interface 122, and power system manager 130. The system configuration identified at 404 can be stored as data that forms part of the power system profile data for the electrical power system.

In some examples, the system configuration can be identified at 404 based on user input received via an operator interface. For example, a human operator of the electrical power system can define aspects of the system configuration identified at 404. Additionally or alternatively, control system 120 can be configured to programmatically identify aspects of system configuration, such as by running a network trace of electrical distribution network 123 and/or a logical network by which logical components, including module interface devices, group managers, and the power system manager of the battery management system are operatively connected.

At 406, the method can include identifying each battery group of the battery system. For example, each battery group of the electrical power system can be identified within the system configuration identified at 404. In some examples, user input received via an operator interface can be used to identify each battery group within the system configuration of the electrical power system. For example, a human operator of the electrical power system can provide a user input via the operator interface that defines aspects of each battery group.

At 408, the method can include establishing a battery group identifier for each battery group of the battery system identified at 406. Each battery group identified at 406 and each battery group identifier established at 408 can be stored as data that forms part of the power system profile data for the electrical power system. As an example, each battery group identifier can be associated with a node representing that battery group within the system configuration. For example, a human operator of the electrical power system can provide a user input via the operator interface that associates a respective battery group identifier with each battery group of the electrical power system.

At 410, the method can include, for each battery group of the battery system, identify a group manager of that battery group. For example, a respective group manager can be identified for each battery group identified at 406. In some examples, user input received via an operator interface can be used to identify the group manager for each battery group. For example, a human operator of the electrical power system can provide a user input via the operator interface that links each battery group with its respective group manager.

At 412, the method can include establishing a group manager identifier for each group manager identified at 410. Each group manager identified at 410 and each group manager identifier established at 412 can be stored as data that forms part of the power system profile data for the electrical power system. As an example, each group manager identifier can be associated with a node representing that group manager within the system configuration. For example, a human operator of the electrical power system can provide a user input via the operator interface that associates a respective group manager identifier with each group manager of the electrical power system.

At 414, the method can include associating each group manager identifier for a group manager with a corresponding battery group identifier for the battery group that is managed by that group manager. As an example, each group manager identifier can be associated with the corresponding battery group identifier within the power system profile data. In some examples, group manager identifiers can be associated with corresponding battery group identifiers based on user input received from a human operator of the electrical power system via an operator interface.

At 416, the method can include establishing battery group profile data for each battery group identified at 406. As part of establishing the battery group profile data at 416, the method can include performing operations 418 through 434 of FIG. 4A.

At 418, the method can include identifying a battery group configuration for each battery group of the battery system. As an example, each battery group configuration can include one or more battery modules. The battery group configuration can indicate a quantity of battery modules of the battery group, and a respective order of the battery modules within the battery group between a cathode-side interface and the anode-side interface of that battery group. The battery group configuration identified at 418 can be stored as data within the battery group profile data established at 416 that forms part of power system profile data established at 402. In some examples, user input from a human operator of the electrical power system can be provided via an operator interface to identify each battery group configuration at 418.

At 420, the method can include, for each battery group of the battery system, identifying each battery module of that battery group. At 422, the method can include establishing a battery module identifier for each battery module of the battery system. The battery module identifier can be associated with a node representing that battery module within the battery group configuration identified at 418 and/or the system configuration identified at 404.

At 424, the method can include associating each battery module identifier of a battery module with a corresponding battery group identifier of a battery group of which that battery module is a member. As an example, each battery manager identifier can be associated with a corresponding battery group identifier within the battery group profile data. In some examples, battery module identifiers can be associated with corresponding battery group identifiers based on user input received from a human operator of the electrical power system via an operator interface.

At 426, the method can include, for each battery module, identify a corresponding module interface device for that battery module. In some examples, module interface devices can be identified for battery modules at 426 based on user input received from a human operator of the electrical power system via an operator interface. At 428, the method can include establishing a module interface device identifier for each module interface device of the electrical power system. The module interface device identifier can be associated with a node representing that module interface device within the battery group configuration identified at 418 and/or the system configuration identified at 404.

At 430, the method can include associating each module interface device identifier with a corresponding battery module identifier for the battery module to which that module interface device is operatively coupled. As an example, each module interface device identifier can be associated with a corresponding battery module identifier within the battery group profile data. In some examples, module interface device identifiers can be associated with corresponding battery module identifiers based on user input received from a human operator of the electrical power system via an operator interface.

At 432, the method can include obtaining a battery module performance specification for each battery module of the battery system. The battery module performance specification can identify a battery chemistry category and/or values for performance parameters of the battery module. Examples of battery chemistry categories include Lithium Ion, Lithium Iron Phosphate, Lithium Cobalt Oxide, Lithium Manganese Oxide, Lithium Nickel Manganese Cobalt Oxide, Lithium Nickel Cobalt Aluminum Oxide, Lithium Titanate, Lead-Acid, Lead-Acid (sealed), Lead-Acid (flooded), Lead-Acid (absorbent glass mat), Lead-Acid (gel / silica), etc. Values for performance parameters that can form part of the battery module performance specification take the form of a rating or stated value of the battery module as provided by the battery module manufacturer. Examples of performance parameters that can form part of the battery module performance specification include: an energy storage capacity rating, an electrical voltage rating, an electrical current rating, an electrical power rating, etc. It will be understood that additional or alternative forms of performance specifications can be obtained for the battery modules at 446. In some examples, the battery module performance specifications obtained at 432 can be received as user input from a human operator of the electrical power system via an operator interface. The battery module performance specification obtained at 432 can be stored as data that forms part of battery group profile data 416.

At 434, the method can include associating the battery module performance specification for each battery module with the battery module identifier of that battery module. As an example, each battery module performance specification can be associated with a corresponding battery module identifier within the battery group profile data. In some examples, battery module performance specifications can be associated with corresponding battery module identifiers based on user input received from a human operator of the electrical power system via an operator interface.

Referring to FIG. 4B, following establishment of the power system profile data at 402 of FIG. 4A, the method at 436 can include measuring one or more performance parameters of the battery system. Performance parameters can be measured at the individual battery module level as a module-specific measurement, at the individual group level as a group-specific measurement, and at the system-wide level as a system-wide measurement. Examples of performance parameters that can be measured at 436 include a stored energy, an energy storage capacity, an electrical voltage, an electrical current, an electrical power. Measuring performance parameters of the battery system at 436 can include operations 438 through 448 of FIG. 4B.

At 438, the method can include, for each battery module of the battery system, obtain a module-specific measurement of each performance parameter via a measurement circuit of the module interface device of that battery module. As previously described, examples of performance parameters that can be measured include a stored energy, an energy storage capacity, an electrical voltage, an electrical current, an electrical power of the battery module. The module-specific measurement of each performance parameter obtained at 438 for each battery module can be stored as performance data within a storage machine accessible to control system 120 that is associated with the battery module identifier of that battery module and a timestamp representing a time at which the measurement was performed.

In some examples, as part of obtaining the module-specific measurements at 438, the method at 440 can include, for each module-specific measurement, commanding the switching circuits of battery modules of the battery system according to a measurement procedure. In a first example, the switching circuit of the battery module to be measured can be commanded to connect the battery module to a test load of the electrical distribution network during the measurement while other battery modules are disconnected from the electrical distribution network by their corresponding switching circuits. In a second example, the switching circuit of the battery module to be measured can be commanded to disconnect the battery module from the electrical distribution network during the measurement, such as in configurations where the measurement circuit incorporates a test load.

At 442, the method can include, for each battery group, obtaining a group-specific measurement of each performance parameter. As previously described, examples of performance parameters that can be measured include a stored energy, an energy storage capacity, an electrical voltage, an electrical current, an electrical power of the battery group. The group-specific measurement of each performance parameter obtained at 442 for each battery group can be stored as performance data within a storage machine accessible to control system 120 that is associated with the battery group identifier of that battery group.

In some examples, as part of obtaining the group-specific measurements at 442, the method at 444 can include, for each performance parameter, combining the module-specific measurements of that performance parameter that were obtained for the battery modules of that battery group at 438 according to the configuration of that battery group identified at 418 to obtain the group-specific measurement of that performance parameter. As an example, in a series configuration of two or more battery modules of a battery group, the electrical voltage of the battery group is equal to the sum of the electrical voltages of the individual battery modules. However, since combining battery modules of different voltages and/or capabilities can cause issues or can damage the battery system in certain configurations, the group-specific measurements obtained at 442 can be achieved based on module-specific measurements without actually connecting the battery modules of that battery group to the electrical distribution network at the same time.

At 446, the method can include obtaining a system-wide measurement of each performance parameter for the battery system. As previously described, examples of performance parameters that can be measured include a stored energy, an energy storage capacity, an electrical voltage, an electrical current, an electrical power of the battery system. The system-wide measurement of each performance parameter obtained at 446 for the battery system can be stored as performance data within a storage machine accessible to control system 120.

In some examples, as part of obtaining the system-wide measurements at 446, the method at 448 can include, for each performance parameter, combining the group-specific measurements of that performance parameter that were obtained for the battery groups of the battery system at 442 according to the configuration of the battery system to obtain the system-wide measurement of that performance parameter. As an example, in a series configuration of two or more battery groups, the electrical voltage of the battery system is equal to the sum of the electrical voltages of the individual battery groups. However, since combining battery groups of different voltages and/or capabilities can cause issues or can damage the battery system in certain configurations, the system-wide measurements obtained at 446 can be achieved based on module-specific measurements and corresponding group-specific measurements without actually connecting the battery groups to the electrical distribution network at the same time.

From operation 436 of FIG. 4B, the process flow of method 400 can proceed to operation 456 of FIG. 4C. Additionally, from operation 436 of FIG. 4B and from operation 402 of FIG. 4A, the process flow of method 400 can proceed to operation 450.

At 450, the method can include identifying modification of the battery system. Examples of modification of the battery system can include addition of one or more battery modules to the battery system, replacement of one or more battery modules of the battery system, removal of one or more battery modules from the battery system, and/or reconfiguration of one or more battery modules of the battery system relative to the electrical distribution network. In some examples, modification of the battery system can be identified at 450 based on user input received by a human operator of the power system via an operator interface. For example, the user input can indicate one or more battery modules and/or one or more battery groups that have been added, removed, replaced, or reconfigured within the battery system.

At 452, the method can include returning to operation 402 of FIG. 4A responsive to identifying modification of the battery system at 450 to update the power system profile data. By returning to operation 402 of FIG. 4A, power system profile data can be established for at least the modifications identified at operation 450, including performing some or all of operations 404 through 434.

At 454, the method can include returning to operation 436 of FIG. 4B responsive to identifying modification of the battery system at 450 to obtain updated measurements one or more performance parameters of the battery system. By returning to operation 436 of FIG. 4B, measurements of performance parameters can be obtained that reflect modification to the battery system, including performing some or all of operations 438 through 448.

Referring to FIG. 4C, at 456, the method can include obtaining target values of one or more performance parameters for the battery system. Target values of performance parameters can be system-wide for the battery system, group-specific for individual battery groups, and module-specific for individual battery modules. As part of obtaining target values at 456, the method can include operations 458 through 462.

At 458, the method can include, for each battery module, obtaining a module-specific target value of each performance parameter for that battery module. As previously described, examples of performance parameters include a stored energy, an energy storage capacity, an electrical voltage, an electrical current, an electrical power. As an example, a module-specific target value of a particular voltage (e.g., 4, 8, 12, 16, 28, 64, etc. volts) can be obtained for some or all of the battery modules of the battery system. In some examples, the module-specific target value of each performance parameter can be an operator-defined target value, and be obtained as a user input received from a human operator via an operator interface. The module-specific target value of each performance parameter that is obtained for a battery module can be stored as data associated with the battery module identifier of that battery module.

At 460, the method can include, for each battery group, obtaining a group-specific target value of each performance parameter for that battery group. As previously described, examples of performance parameters include a stored energy, an energy storage capacity, an electrical voltage, an electrical current, an electrical power. As an example, a group-specific target value of a particular voltage (e.g., 44, 72, 1500, etc. volts) can be obtained for some or all of the battery groups of the battery system. In some examples, the group-specific target value of each performance parameter can be an operator-defined target value, and be obtained as a user input received from a human operator via an operator interface. The group-specific target value of each performance parameter that is obtained for a battery group can be stored as data associated with the battery group identifier of that battery group.

At 462, the method can include, obtaining a system-wide target value of each performance parameter for the battery system. As previously described, examples of performance parameters include a stored energy, an energy storage capacity, an electrical voltage, an electrical current, an electrical power. The system-wide target value of each performance parameter can correspond to values suitable for a particular electrical source (e.g., 114 of FIG. 1) and/or electrical load (e.g., 116 of FIG. 1). As an example, a system-wide target value of an electrical voltage (e.g., 1500 volts) can be obtained. In some examples, the system-wide target value of each performance parameter can be an operator-defined target value, and be obtained as a user input received from a human operator via an operator interface. The group-specific target value of each performance parameter that is obtained for a battery group can be stored as data associated with the battery group identifier of that battery group.

At 464, the method can include, for each battery module of the battery system, identify that battery module as being available or unavailable. As part of operation 464, the method at 466 can include comparing the measured value of each performance parameter for the battery module to the module-specific target value of that performance parameter for the battery module. For example, battery modules that exhibit measured values of the performance parameter that meet or are within a threshold range of the module-specific target of that performance parameter can be identified as being available. In this example, battery modules that do not exhibit measured values of the performance parameter that meet or are within a threshold range of the module-specific target of that performance parameter can be identified as being unavailable. It will be understood that the threshold range in the preceding examples can provide that the measured value be equal to or greater than the target value for certain performance parameters (e.g., energy storage capacity, electrical current, electrical power). Battery modules identified as being available or unavailable at 464 can be stored as data in a data storage machine that is associated with the corresponding battery module identifiers of those battery modules.

At 468, the method can include, for each battery group of the battery system, identify that battery group as being available or unavailable. As part of operation 468, the method at 470 can include comparing the measured value of each performance parameter for the battery group to the group-specific target value of that performance parameter for the battery group. For example, battery groups that exhibit measured values of the performance parameter that meet or are within a threshold range of the group-specific target of that performance parameter can be identified as being available. In this example, battery groups that do not exhibit measured values of the performance parameter that meet or are within a threshold range of the group-specific target of that performance parameter can be identified as being unavailable. It will be understood that the threshold range in the preceding examples can provide that the measured value be equal to or greater than the target value for certain performance parameters (e.g., energy storage capacity, electrical current, electrical power). Battery groups identified as being available or unavailable at 468 can be stored as data in a data storage machine that is associated with the corresponding group identifiers of those battery groups.

At 472, the method can include selecting a first subset of battery modules of the battery system to be connected to the electrical distribution network of the electrical power system. The first subset of battery modules selected at 472 can be stored as data that is associated with the corresponding battery module identifiers of those battery modules within a data storage machine. In some examples, the first subset of battery modules can be selected at 472 responsive to user input received from a human operator of the electrical power system via an operator interface.

Furthermore, as indicated at 474, the first subset of battery modules selected at 472 can be based on the target values of the performance parameter obtained at 456, including some or all of the module-specific, group-specific, and system-wide target values. As indicated at 476, the first subset of battery modules selected at 472 can be based on measurements of the performance parameters obtained at 436 of FIG. 4B. For example, the first subset of battery modules can be selected based on the module-specific measurement of one or more performance parameters obtained for each battery module of at least the first subset of battery modules. In this example, battery modules can be selected to fulfill one or more module-specific target values, one or more group-specific target values, and/or one or more system-wide target values. As indicated at 478, the first subset of battery modules selected at 472 can be selected based on the power system configuration identified at 404, including the battery group configuration identified for each battery group identified at 418.

In some examples, the first subset of battery modules selected at 472 can be selected from battery modules identified as available at 464. For example, the first subset of battery modules selected at 472 does not include any battery modules identified as unavailable at 464. Additionally or alternatively, the first subset of battery modules selected at 472 can be selected from battery groups identified as available at 468. For example, the first subset of battery modules selected at 472 does not include any battery modules that form part of battery groups identified as unavailable at 468.

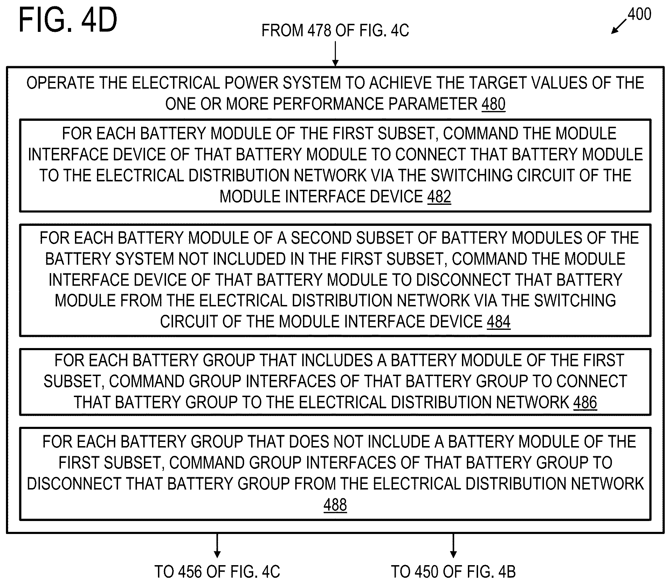

As an illustrative example of operation 472, where an electrical power system includes a parallel configuration of a first series of battery modules and/or battery groups and a second series of battery modules and/or battery groups, the first subset of battery modules can be selected so that the voltage of the first series configuration is equal to the voltage of the second series configuration, and further so that the battery system has a system-wide target capability in terms of system-wide electrical current, electrical power, and energy storage capacity. From operation 472 of FIG. 4C, the process flow of method 400 can proceed to operation 480 of FIG. 4D.

Referring to FIG. 4D, at 480, the method can include operating the electrical power system to achieve the target values of the one or more performance parameters. As part of operation 480, the method can include performing some or all of operations 482 through 488.

At 482, the method can include, for each battery module of the first subset selected at 472, command the module interface device of that battery module to connect that battery module to the electrical distribution network via the switching circuit of the module interface device. For example, power system manager 130 of FIG. 1 can instruct a group manager (e.g., of group managers 132) operatively coupled to the module interface device to command the module interface device to connect the battery module of battery system 110 to electrical distribution network 123 via the switching circuit.

At 484, the method can include, for each battery module of a second subset of battery modules of the battery system not included in the first subset, commanding the module interface device of that battery module to disconnect that battery module from the electrical distribution network via the switching circuit of the module interface device. For example, power system manager 130 of FIG. 1 can instruct a group manager (e.g., of group managers 132) operatively coupled to the module interface device to command the module interface device to disconnect the battery module of battery system 110 from electrical distribution network 123 via the switching circuit.

In examples where the electrical power system includes switchable group interfaces, such as cathode-side group interface 150 and anode-side group interface 152, the method can include commanding the group interfaces to connect or disconnect the battery groups with respect to the electrical distribution network. For example, at 486, the method can include, for each battery group that includes a battery module of the first subset selected at 472, commanding the cathode-side and anode-side group interfaces of that battery group to connect that battery group to the electrical distribution network. For example, the group manager of the battery group can be instructed by the power system manager to command the cathode-side and anode-side group interfaces to connect the battery group to the electrical distribution network. In some examples, at 488, the method can include, for each battery group that does not include a battery module of the first subset, commanding the cathode-side and anode-side group interfaces of that battery group to disconnect that battery group from the electrical distribution network. However, in other examples, operation 488 is not performed, such as where a series configuration of battery groups rely on the cathode-side and anode-side group interfaces for connection of one or more battery modules to the electrical distribution network.

From operation 480 of FIG. 4D, the method can proceed to operation 450 of FIG. 4B to monitor for modifications to the battery system and/or to operation 456 of FIG. 4C to monitor for updates to the target values of one or more performance parameters.

In some examples, the methods and operations described herein can be performed a computing system of one or more computing devices. Such methods and operations can be implemented as a computer-application program or service, an application-programming interface (API), a library, and/or other computer-program product.

FIG. 5 is a schematic diagram depicting additional aspects of control system 120 of FIG. 1. In the example of FIG. 5, control system 120 includes a computing system 500 of one or more computing devices 502 that can perform the methods and operations described herein, including method 400 of FIGS. 4A through 4D. Computing system 500 is an example of an article of manufacture 501.

Computing system 500 includes a logic machine 510, a storage machine 512, and an input / output (I/O) subsystem 514. Computing system 500 is shown in FIG. 5 simplified form. Computing system 500 or computing devices 502 thereof can take the form of one or more personal computers, server computers, network computing devices, mobile computing devices, and/or other computing devices, as examples.

Logic machine 510 includes one or more physical logic devices configured to execute instructions, such as instructions 516 stored at storage machine 512. For example, logic machine 510 can execute instructions 516 that are part of one or more applications, services, programs, routines, libraries, objects, components, data structures, or other logical constructs. Instructions 516 can be executed by logic machine 510 to perform the methods and operations described herein, which can include performing one or more tasks, implementing data types, transforming the state of one or more components, achieving one or more technical effects, or otherwise arrive at one or more desired results.

Logic machine 510 can include one or more processors configured to execute software instructions. Additionally or alternatively, logic machine 510 can include one or more hardware or firmware logic machines configured to execute hardware or firmware instructions. Processors of logic machine 510 can be single-core or multi-core, and the instructions executed thereon can be configured for sequential, parallel, and/or distributed processing. Individual components of logic machine 510 can be distributed among two or more separate devices, which can be remotely located and/or configured for coordinated processing. Aspects of logic machine 510 can be virtualized and executed by remotely accessible, networked computing devices configured in a cloud-computing configuration.

Storage machine 512 includes one or more physical devices configured to hold instructions 516 and data 518 executable by logic machine 510 to perform the methods and operations described herein. When such methods and operations are performed, the state of storage machine 512 can be transformed-e.g., to hold different data within data 518.

Storage machine 512 can include removable and/or built-in devices. Storage machine 512 can include optical memory, semiconductor memory (e.g., RAM, EPROM, EEPROM, etc.), and/or magnetic memory (e.g., hard-disk drive, floppy-disk drive, tape drive, MRAM, etc.), among other forms of storage. Storage machine 512 can include volatile, nonvolatile, dynamic, static, read/write, read-only, random-access, sequential-access, location-addressable, file-addressable, and/or content-addressable devices.

Aspects of logic machine 510 and storage machine 512 can be integrated together into one or more hardware-logic components. Such hardware-logic components can include field-programmable gate arrays (FPGAs), program- and application-specific integrated circuits (PASIC / ASICs), program- and application-specific standard products (PSSP / ASSPs), system-on-a-chip (SOC), and complex programmable logic devices (CPLDs), for example.

FIG. 5 schematically depicts instructions 516 in further detail, including an operator interface program 520, a system manager program 522, and a group manager program 524. The term "program" can be used to describe an aspect of computing system 500 implemented to perform a particular function. Such programs can be instantiated via logic machine 510 executing instructions 516 held by storage machine 512. The programs described herein can encompass individual or groups of executable files, data files, libraries, drivers, scripts, database records, etc. Multiple instances of the programs described herein can be instantiated from the same portion of instructions 516. For example, multiple instances of group manager program 524 can be instantiated for each group manager of FIG. 1.

Operator interface program 520 upon execution by logic machine 510 can provide an operator interface 526 by which a human operator can control power system 100 of FIG. 1, including battery system 110 and battery management system 112. In some examples, operator interface 526 can be presented at a client computing device 528 that is operatively coupled to computing system 500 via I/O interface devices 514. As an example, operator interface 526 can include or take the form of a graphical user interface that is presented at client device 528. As another example, operator interface 526 can be presented via one or more input devices and/or output devices of I/O interface devices 514, as described herein. User input from a human operator of the electrical power system can be received via operator interface 526 as previously described with reference to method 400 of FIGS. 4A through 4D.

System manager program 522 upon execution by logic machine 510 can provide power system manager 130 of FIG. 1. Thus, it will be understood that power system manager 130 can include hardware aspects (e.g., logic machine 510, storage machine 512, I/O subsystem 514) of computing system 500 executing system manager program 522. Furthermore, in some examples, operator interface program 520 can form part of system manager program 522.

Group manager program 524 upon execution by logic machine 510 can provide a respective instance of group managers 132 of FIG. 1. Thus, it will be understood that group managers 132-1.1 through 132-1.N, 132-2.1 through 132-1.N, 132-M.1 through 132-M.N, etc. can include hardware aspects (e.g., logic machine 510, storage machine 512, I/O subsystem 514) of computing system 500 executing group manager program 524 to instantiate multiple instances of the group manager program. In some examples, each group manager of battery management system 112 can be implemented as a respective computing device of computing system 500 executing a respective instance of group manager program 524. In such examples, power system manager 130 can be implemented as a separate computing device of computing system 500 executing system manager program 522 from computing devices that execute group manager program 524. As another example, the programs of instructions 516 can be executed by the same computing device or set of two or more computing devices of computing system 500.

FIG. 5 schematically depicts data 518 in further detail, including power system profile data 530, performance data 532, and performance parameters 534. While various examples of data 518 are described herein, it will be understood that data 518 can include additional forms of data not depicted in FIG. 5.

Power system profile data 530 is an example of the power system profile data that can be established at operation 402 of FIG. 4A. Power system profile data 530 can include a power system identifier 540 that identifies power system 100 within an operating environment that can contain multiple power systems. Power system profile data 530 can include power system configuration data 542 that is associated with power system identifier 540. Power system configuration data 542 can include a power system configuration 544 and multiple battery group profile datasets 546 corresponding to multiple battery groups of the battery system.

Power system configuration 544 is an example of the power system configuration identified at operation 404 of FIG. 4A. Power system configuration 544 can include a data representation of a physical, electrical, and logical configuration of power system 100, including a respective location of each component of power system 100 relative to other components within a physical, electrical, and logical context. For example, power system map 554 can identify a location of each battery group within battery system 110, including a respective order of battery groups within series configurations 140-1, 140-2, 140-M, and parallel configuration 142.

Battery group profile datasets 546 can include a respective set of battery group profile data 550 for each battery group of battery system 110. Battery group profile data 550 is an example of the battery group profile data that can be established at operation 416 of FIG. 4A. Battery group profile data 550 can include a battery group identifier 552 that identifies the battery group within battery system 110 that contains multiple battery groups. Battery group identifier 552 is an example of the battery group identifiers that can be established at operation 408 of FIG. 4A. Battery group profile data 550 can include a group manager identifier 554 that identifies the group manager that is associated with the battery group identified by battery group identifier 552. Group manager identifier 554 is an example of the group manager identifiers that can be established at operation 412 of FIG. 4A. As previously described at operation 414 of FIG. 4A, each group manager identifier can be associated with a corresponding battery group identifier. For example, in the example of FIG. 1, group manager 132-1.1 is associated with battery group 118-1.1, and group manager 132-1.N is associated with battery group 118-1.N within power system 100. The association established or recorded between each battery group and each group manager by a respective instance of battery group profile data 550 and identifiers 552, 554 enables control system 120 to determine the group manager that is operable to control operation of a particular battery group.

Battery group profile data 550 can include battery group configuration data 556 for the battery group identified by battery group identifier 552. Battery group configuration data 556 can include a battery group configuration 558 and multiple battery module profile datasets 560.

Battery group configuration 558 can include a data representation of a physical, electrical, and logical configurations of the battery group identified by battery group identifier 552, including a respective location of each battery module of the battery group relative to other battery modules of the battery group within a physical, electrical, and logical context. For example, battery group configuration 558 can identify a location of each battery module within the battery group identified by battery group identifier 552, including a respective order of battery modules within that battery group. Battery group configuration 558 is an example of the battery group configuration that is identified at operation 418 of FIG. 4A.

Battery module profile datasets 560 can include a respective instance of battery module profile data 562 for each battery module of the battery group. Battery module profile data 562 can include a battery module identifier 564 that identifies the battery module within the battery group identified by battery group identifier 552 that contains multiple battery modules. Battery module identifier 564 is an example of the battery module identifier established at operation 422 of FIG. 4A.

Module profile data 562 includes a module interface device identifier 566 that identifies the module interface device that is operatively coupled to the battery module identified by battery module identifier 564. Module interface device identifier 566 is an example of the module interface device identifier established at operation 428 of FIG. 4A. An association of module interface device identifier 566 with battery module identifier 564 within module profile data 562 enables control system 120 to determine which module interface device controls operation of each battery module of battery system 110. As previously described at operation 430 of FIG. 4A, each module interface device identifier can be associated with a corresponding battery module identifier.

Module profile data 562 can include a battery module performance specification 568 that identifies respective values for one or more performance parameters 534 for the battery module identified by battery module identifier 564. Battery module performance specification 568 is an example of the battery module performance specification obtained at operation 432 of FIG. 4A. Examples of performance parameters 534 can include stored energy 570, energy storage capacity 572, electrical voltage 574, electrical current 576, electrical power 578, and other 580 performance parameters (e.g., age, charge cycles, discharge cycles, temperature, etc.). Within the context of battery module performance specification 568, performance parameters 534 can represent stated performance parameters of the battery module - e.g., the manufacturer's rating of the battery module.

In contrast to battery module performance specification 568 that can be provided for each battery module of battery system 110, control system 120 can measure actual performance of battery system 110, which can be stored in data 518 as performance data 532. Performance data 532 is an example of measurements of performance parameters obtained at operation 436 of FIG. 4B. It will be understood that actual performance of battery system 110 represented by performance data 532, including the actual performance of the various battery groups and battery modules of the battery system can differ from the battery module performance specifications provided at 568. For example, factors such as age, charge cycles, discharge cycles, temperature, malfunction, and damage can impact actual performance of battery modules, thereby impacting actual performance of the battery groups and of battery system 110.

As previously described with reference to method 400 of FIG. 4A through 4D, performance parameters 534 can be measured by control system 120 at the individual battery module level, individual battery group level, and at the battery system level. Examples of performance data 532 can include battery module-specific measurements 580 of performance parameters 534 for each battery module of battery system 110, battery group-specific measurements 582 of performance parameters 534 for each battery group of battery system 110, and system-wide measurements 584 of performance parameters 534 for battery system 110. Battery module-specific measurements 580 can include a measured value of stored energy 570, storage capacity 572, electrical voltage 574, electrical current 576, electrical power 578, and other 580 performance parameters for each battery module of battery system 110. Battery group-specific measurements 582 can include a measured value of stored energy 570, storage capacity 572, electrical voltage 574, electrical current 576, electrical power 578, and other 580 performance parameters for each battery group of battery system 110. System-wide measurements 584 can include a measured value of stored energy 570, storage capacity 572, electrical voltage 574, electrical current 576, electrical power 578, and other 580 performance parameters for battery system 110.

Performance data 532 can include battery module-specific targets 586 of performance parameters 534 for each battery module of battery system 110, battery group-specific targets 588 of performance parameters 534 for each battery group of battery system 110, and system-wide targets 590 of performance parameters 534 for battery system 110. For each battery module of battery system 110, battery module-specific targets 586 can include a target value for each performance parameter of performance parameters 534, including stored energy 570, storage capacity 572, electrical voltage 574, electrical current 576, electrical power 578, and other 580 performance parameters. For each battery group of battery system 110, battery group-specific targets 588 can include a target value for each performance parameter of performance parameters 534, including stored energy 570, storage capacity 572, electrical voltage 574, electrical current 576, electrical power 578, and other 580 performance parameters. For battery system 110, system-wide targets 590 can include a target value for each performance parameter of performance parameters 534, including stored energy 570, storage capacity 572, electrical voltage 574, electrical current 576, electrical power 578, and other 580 performance parameters.

For each battery module of battery system 110, control system 120 can compare battery module-specific measurements 580 for that battery module to battery module-specific targets 586 for that battery module on a performance parameter basis from among performance parameters 534 to determine whether battery module-specific measurements 580 for each performance parameter meet or are within a threshold range of battery module-specific targets 586 for each performance parameter. Control system 120 can determine whether each battery module is operating within an acceptable range based on this comparison. For example, control system 120 can determine whether to activate or deactivate each battery module of battery system 110 based on whether the battery module is operating within the acceptable range.

In some examples, battery module-specific targets 586 can be initially set by control system 120 based on battery module performance specification 568 identified for that battery module. Additionally or alternatively, battery module-specific targets 586 can be defined by a human operator via user input received via operator interface 526. Furthermore, in some examples, battery module-specific targets 586 can be programmatically updated by control system 120 based on or responsive to battery module-specific measurements 580 to reflect actual performance of each battery module of battery system 110. It will be understood that battery module-specific measurements 580 and battery module-specific targets 586 can differ between or among the battery modules of battery system 110 due to differences between or among the battery modules.

For each battery group of battery system 110, control system 120 can compare battery group-specific measurements 582 for that battery group to battery group-specific targets 588 for that battery group on a performance parameter basis from among performance parameters 534 to determine whether battery group-specific measurements 582 for each performance parameter meet or are within a threshold range of battery group-specific targets 588 for each performance parameter. Control system can determine whether each battery group is operating within an acceptable range based on this comparison.

In some examples, battery group-specific targets 588 can be initially set by control system 120 based on an aggregation of battery module performance specification 568 identified for each battery module of the battery group. Additionally or alternatively, battery group-specific targets 588 can be defined by a human operator via user input received via operator interface 526. Furthermore, in some examples, battery group-specific targets 588 can be programmatically updated by control system 120 based on battery group-specific measurements 582 to reflect actual performance of each battery group of battery system 110. It will be understood that battery group-specific measurements 582 and battery group-specific targets 588 can differ between or among the battery groups of battery system 110 depending, for example, on the battery module composition of each battery group.

Control system 120 can compare system-wide measurements 584 for battery system 110 to system-wide targets 590 for the battery system on a performance parameter basis from among performance parameters 534 to determine whether system-wide measurements 584 for each performance parameter meet or are within a threshold range of system-wide targets 590 for each performance parameter. Control system can determine whether battery system 110 is operating within an acceptable range based on this comparison.

In some examples, system-wide targets 590 can be initially set by control system 120 based on an aggregation of battery module performance specification 568 identified for each battery module of the battery system. Additionally or alternatively, system-wide targets 590 can be defined by a human operator via user input received via operator interface 526. As an example, system-wide targets 590 can be defined, at least in part, by performance parameters or other features of electrical source 114 and/or electrical load 116. Furthermore, in some examples, system-wide targets 590 can be programmatically updated by control system 120 based on system-wide measurements 584 to reflect actual performance of battery system 110.

Data 518 can include a registry 592 of available battery modules 594 (e.g., identified at operation 464 of FIG. 4C) among the entire set of all battery modules of battery system 110, and unavailable battery modules 595 (e.g., identified at operation 464 of FIG. 4C) among the entire set of all battery modules of battery system 110. Registry 592 can further identify the first subset of battery modules 596 of battery system 110 that were selected at operation 472 of FIG. 4C, and the second subset of battery modules 597 that are not included in the first subset 596. In this example, the first subset 596 includes battery module identifiers that are connected to the electrical distribution network of the electrical power system, and the second subset 597 includes battery module identifiers that are not connected to the electrical distribution network of the electrical power system.

Data 518 can be output by operator interface program 520 for presentation via operator interface 526. As an example, input / output interface devices 514 and/or client device 528 can include one or more output devices such as a graphical display, audio speaker, indicator bulbs, etc. by which data 518 can be presented. Input / output interface devices 514 and/or client device 528 can include one or more input devices by which user input can be provided to computing system 500 by a human operator. Examples of input devices include a keyboard, computer mouse, touch-display, microphone, controller device, instrument panel, etc. Furthermore, input / output interface devices 514 can include one or more communication interface devices that enable computing system 500 or computing devices 502 of the computing system to communicate with and/or exchange electrical energy with other devices, including client device 528, module interface devices, group managers 132, power system manager 130, power system interface 122, cathode-side interface 150, and anode-side interface 152. Such communications can be transmitted over wired and/or wireless communications links of one or more communications networks. Communications networks can include personal area networks, local area networks, and wide area networks (e.g., the Internet).

Further, the disclosure comprises configurations according to the following examples.

Example 1. An electrical power system, comprising: a battery system that includes multiple battery modules; an electrical distribution network for the battery system that includes a cathode-side interface and an anode-side interface; for each battery module of the battery system, a respective module interface device that includes a measurement circuit operable to measure one or more performance parameters of that battery module, and a switching circuit operable to connect and disconnect that battery module with respect to the electrical distribution network independent of other battery modules of the battery system; and a control system operatively coupled to each module interface device, wherein the control system is configured to: obtain a target value of a performance parameter for the battery system; for each battery module of the battery system, obtain a module-specific measurement of the performance parameter via the measurement circuit of the module interface device of that battery module, select a first subset of battery modules of the battery system to be connected to the electrical distribution network based on the target value of the performance parameter and the module-specific measurement of the performance parameter obtained for each battery module of at least the first subset of battery modules, for each battery module of the first subset, command the module interface device of that battery module to connect that battery module to the electrical distribution network via the switching circuit of the module interface device, and for each battery module of a second subset of battery modules of the battery system not included in the first subset, command the module interface device of that battery module to disconnect that battery module from electrical distribution network via the switching circuit of the module interface device.

Example 2. The electrical power system of Example 1, wherein the multiple battery modules of the battery system are organized into two or more battery groups in which each battery group includes two or more battery modules of the multiple battery modules; and wherein the control system further includes: for each battery group of the battery system, a group manager operable to command each module interface device electrically coupled to a battery module of that battery group to connect and disconnect that battery module with respect to the electrical distribution network via the switching circuit of the module interface device.

Example 3. The electrical power system of Example 2, wherein the target value of the performance parameter for the battery system is a battery group-specific target value of the performance parameter for each battery group of the battery system.

Example 4. The electrical power system of Example 2, wherein a first battery group of the two or more battery groups is arranged in a parallel configuration with a second battery group of the two or more battery groups by the electrical distribution network; and wherein each battery module of each battery group of the two or more battery groups is arranged in a series configuration with other battery modules of that battery group by the electrical distribution network.

Example 5. The electrical power system of Example 2, wherein a first battery group of the two or more battery groups is arranged in a series configuration with a second battery group of the two or more battery groups by the electrical distribution network.

Example 6. The electrical power system of any of Examples 1-2, wherein the target value of the performance parameter for the battery system is a system-wide target value of the performance parameter the battery system.

Example 7. The electrical power system of any of Examples 1-2, wherein the target value of the performance parameter for the battery system is a module-specific target value of the performance parameter for each battery module of the battery system.

Example 8. The electrical power system of any of Examples 1-7, wherein the performance parameter includes one or more of: a stored energy, an energy storage capacity, an electrical voltage, an electrical current, an electrical power.

Example 9. The electrical power system of any of Examples 1-8, wherein the multiple batteries of the battery system have two or more different performance specifications among the multiple batteries that differ with respect to a battery chemistry category and/or the performance parameter.

Example 10. The electrical power system of any of Examples 1-9, wherein the target value of the performance parameter is an operator-defined target value.

Example 11. A method of managing operation of an electrical power system performed by a computing system of one or more computing devices, the method comprising: obtaining a target value of a performance parameter for a battery system of the electrical power system, wherein the battery system includes multiple battery modules; for each battery module of the battery system, obtaining a module-specific measurement of the performance parameter via a measurement circuit of a module interface device operatively coupled to that battery module, selecting a first subset of battery modules of the battery system to be connected to an electrical distribution network for the battery system based on the target value of the performance parameter and the module-specific measurement of the performance parameter obtained for each battery module of at least the first subset of battery modules, for each battery module of the first subset, commanding the module interface device of that battery module to connect that battery module to the electrical distribution network via a switching circuit of the module interface device, and for each battery module of a second subset of battery modules of the battery system not included in the first subset, commanding the module interface device of that battery module to disconnect that battery module from electrical distribution network via the switching circuit of the module interface device.

Example 12. The method of Example 11, wherein the multiple battery modules of the battery system are organized into two or more battery groups in which each battery group includes two or more battery modules of the multiple battery modules; and wherein the target value of the performance parameter for the battery system is a group-specific target value of the performance parameter for each battery group of the battery system.

Example 13. The method of Example 12, wherein a first battery group of the two or more battery groups is arranged in a parallel configuration with a second battery group of the two or more battery groups by the electrical distribution network; and wherein each battery module of each battery group of the two or more battery groups is arranged in a series configuration with other battery modules of that battery group by the electrical distribution network.

Example 14. The method of Example 12, wherein a first battery group of the two or more battery groups is arranged in a series configuration with a second battery group of the two or more battery groups by the electrical distribution network.

Example 15. The method of any of Examples 11-14, wherein the target value of the performance parameter for the battery system is a battery group-specific target value of the performance parameter for each battery group of the battery system.

Example 16. The method of any of Examples 11-14, wherein the target value of the performance parameter for the battery system is a module-specific target value of the performance parameter for each battery module of the battery system.

Example 17. The method of any of Examples 11-16, wherein the performance parameter includes one or more of: a stored energy, an energy storage capacity, an electrical voltage, an electrical current, an electrical power.

Example 18. The method of any of Examples 11-17, wherein the multiple batteries of the battery system have two or more different performance specifications among the multiple batteries that differ with respect to a battery chemistry category and/or the performance parameter.

Example 19. An article of manufacture for managing operation of an electrical power system, the article of manufacture comprising: a data storage machine of a computing system having instructions stored thereon executable by a logic machine of the computing system to: obtain a target value of a performance parameter for a battery system of the electrical power system, wherein the battery system includes multiple battery modules; for each battery module of the battery system, obtain a module-specific measurement of the performance parameter via a measurement circuit of a module interface device operatively coupled to that battery module, select a first subset of battery modules of the battery system to be connected to an electrical distribution network for the battery system based on the target value of the performance parameter and the module-specific measurement of the performance parameter obtained for each battery module of at least the first subset of battery modules, for each battery module of the first subset, command the module interface device of that battery module to connect that battery module to the electrical distribution network via a switching circuit of the module interface device, and for each battery module of a second subset of battery modules of the battery system not included in the first subset, command the module interface device of that battery module to disconnect that battery module from electrical distribution network via the switching circuit of the module interface device.

Example 20. The article of manufacture of Example 19, wherein the multiple batteries of the battery system have two or more different performance specifications among the multiple batteries that differ with respect to a battery chemistry category and/or the performance parameter; and wherein the performance parameter includes one or more of: a stored energy, an energy storage capacity, an electrical voltage, an electrical current, an electrical power.

It will be understood that the configurations and/or approaches described herein are exemplary in nature, and that these specific embodiments or examples are not to be considered in a limiting sense, because numerous variations are possible. The specific routines or methods described herein may represent one or more of any number of processing strategies. As such, various acts illustrated and/or described may be performed in the sequence illustrated and/or described, in other sequences, in parallel, or omitted. Likewise, the order of the above-described processes may be changed.

The subject matter of the present disclosure includes all novel and non-obvious combinations and sub-combinations of the various processes, systems and configurations, and other features, functions, acts, and/or properties disclosed herein, as well as any and all equivalents thereof.

## Claims

1. An electrical power system (100), comprising:
a battery system (110) that includes multiple battery modules (210-1.1, 210.1.N);
an electrical distribution network (123) for the battery system (110) that includes a cathode-side interface (125) and an anode-side interface (127);
for each battery module (210) of the battery system (110), a respective module interface device (212) that includes a measurement circuit (340) operable to measure one or more performance parameters (534) of that battery module (210), and a switching circuit (350) operable to connect and disconnect that battery module (210) with respect to the electrical distribution network (123) independent of other battery modules of the battery system (110); and
a control system (120) operatively coupled to each module interface device (212), wherein the control system (120) is configured to:
obtain a target value (586, 588, 590) of a performance parameter (534) for the battery system (110);
for each battery module (210) of the battery system (110), obtain a module-specific measurement (580) of the performance parameter (534) via the measurement circuit (340) of the module interface device (212) of that battery module (210),
select a first subset of battery modules (472) of the battery system (110) to be connected to the electrical distribution network (123) based on the target value (586, 588, 590) of the performance parameter (534) and the module-specific measurement (580) of the performance parameter (534) obtained for each battery module (210) of at least the first subset of battery modules (472),
for each battery module (210) of the first subset (472), command the module interface device (212) of that battery module (210) to connect that battery module (210) to the electrical distribution network (123) via the switching circuit (350) of the module interface device (212), and
for each battery module (210) of a second subset of battery modules (484) of the battery system (110) not included in the first subset (472), command the module interface device (212) of that battery module (210) to disconnect that battery module (210) from electrical distribution network (123) via the switching circuit (350) of the module interface device (212).

2. The electrical power system (100) of claim 1, wherein the multiple battery modules (210-1.1, 210.1.N) of the battery system (110) are organized into two or more battery groups (118-1.1, 118-1.2, 118-2.1) in which each battery group (118) includes two or more battery modules (210-1.1, 210-1.2) of the multiple battery modules (210); and
wherein the control system (120) further includes:
for each battery group (118) of the battery system (110), a group manager (132) operable to command each module interface device (212) electrically coupled to a battery module (210) of that battery group (118) to connect and disconnect that battery module (210) with respect to the electrical distribution network (123) via the switching circuit (350) of the module interface device (212).

3. The electrical power system (100) of claim 2, wherein the target value (586, 588, 590) of the performance parameter (534) for the battery system (110) is a battery group-specific target value (588) of the performance parameter (534) for each battery group (118) of the battery system (110).

4. The electrical power system (100) of claim 2, wherein a first battery group (118-1.1) of the two or more battery groups (118-1.1, 118-1.2, 118-2.1) is arranged in a parallel configuration (142) with a second battery group (118-2.1) of the two or more battery groups (118-1.1, 118-1.2, 118-2.1) by the electrical distribution network (123); and
wherein each battery module (210) of each battery group (118) of the two or more battery groups (118-1.1, 118-1.2, 118-2.1) is arranged in a series configuration (140) with other battery modules of that battery group (118) by the electrical distribution network (123).

5. The electrical power system (100) of claim 2, wherein a first battery group (118-1.1) of the two or more battery groups (118-1.1, 118-1.2, 118-2.1) is arranged in a series configuration (140) with a second battery group (118-1.2) of the two or more battery groups (118-1.1, 118-1.2, 118-2.1) by the electrical distribution network (123).

6. The electrical power system (100) of any one of the preceding claims, wherein the target value (586, 588, 590) of the performance parameter (534) for the battery system (110) is either a system-wide target value (590) of the performance parameter (534) the battery system (110), or a module-specific target value (586) of the performance parameter (534) for each battery module (210) of the battery system (110).

7. The electrical power system (100) of any one of the preceding claims, wherein the performance parameter (534) includes one or more of: a stored energy (570), an energy storage capacity (572), an electrical voltage (574), an electrical current (576), an electrical power (578).

8. The electrical power system (100) of any one of the preceding claims, wherein the multiple batteries (210) of the battery system (110) have two or more different performance specifications (568) among the multiple batteries (210) that differ with respect to a battery chemistry category (568) and/or the performance parameter (534).

9. A method of managing operation of an electrical power system (100) performed by a computing system of one or more computing devices, the method comprising:
obtaining a target value (586, 588, 590) of a performance parameter (534) for a battery system (110) of the electrical power system (100), wherein the battery system (110) includes multiple battery modules (210-1.1, 210.1.N);
for each battery module (210) of the battery system (110), obtaining a module-specific measurement (580) of the performance parameter (534) via a measurement circuit (340) of a module interface device (212) operatively coupled to that battery module (210),
selecting a first subset of battery modules (472) of the battery system (110) to be connected to an electrical distribution network (123) for the battery system (110) based on the target value (586, 588, 590) of the performance parameter (534) and the module-specific measurement (580) of the performance parameter (534) obtained for each battery module (210) of at least the first subset of battery modules (472),
for each battery module (210) of the first subset (472), commanding the module interface device (212) of that battery module (210) to connect that battery module (210) to the electrical distribution network (123) via a switching circuit (350) of the module interface device (212), and
for each battery module (210) of a second subset of battery modules (484) of the battery system (110) not included in the first subset (472), commanding the module interface device (212) of that battery module (210) to disconnect that battery module (210) from electrical distribution network (123) via the switching circuit (350) of the module interface device (212).

10. The method of claim 9, wherein the multiple battery modules (210-1.1, 210.1.N) of the battery system (110) are organized into two or more battery groups (118-1.1, 118-1.2, 118-2.1) in which each battery group (118) includes two or more battery modules (210-1.1, 210.1.2) of the multiple battery modules (210-1.1, 210.1.N); and
wherein the target value (586, 588, 590) of the performance parameter (534) for the battery system (110) is a group-specific target value (588) of the performance parameter (534) for each battery group (118) of the battery system (110).

11. The method of claim 9, wherein the target value (586, 588, 590) of the performance parameter (534) for the battery system (110) is a battery group-specific target value (588) of the performance parameter (534) for each battery group (118) of the battery system (110).

12. The method of claim 9, wherein the target value (586, 588, 590) of the performance parameter (534) for the battery system (110) is a module-specific target value (586) of the performance parameter (534) for each battery module (210) of the battery system (110).

13. The method of claim 9, wherein the multiple batteries (210) of the battery system (110) have two or more different performance specifications (568) among the multiple batteries (210) that differ with respect to a battery chemistry category (568) and/or the performance parameter (534).

14. An article of manufacture for managing operation of an electrical power system (100), the article of manufacture comprising:
a data storage machine of a computing system having instructions stored thereon executable by a logic machine of the computing system to:
obtain a target value (586, 588, 590) of a performance parameter (534) for a battery system (110) of the electrical power system (100), wherein the battery system (110) includes multiple battery modules (210-1.1, 210.1.N);
for each battery module (210) of the battery system (110), obtain a module-specific measurement (580) of the performance parameter (534) via a measurement circuit of a module interface device (212) operatively coupled to that battery module (210),
select a first subset of battery modules (472) of the battery system (110) to be connected to an electrical distribution network (123) for the battery system (110) based on the target value (586, 588, 590) of the performance parameter (534) and the module-specific measurement (580) of the performance parameter (534) obtained for each battery module (210) of at least the first subset of battery modules (472),
for each battery module (210) of the first subset (472), command the module interface device (212) of that battery module (210) to connect that battery module (210) to the electrical distribution network (123) via a switching circuit (350) of the module interface device (212), and
for each battery module (210) of a second subset of battery modules (484) of the battery system (110) not included in the first subset (472), command the module interface device (212) of that battery module (210) to disconnect that battery module (210) from electrical distribution network (123) via the switching circuit (350) of the module interface device (212).

15. The article of manufacture of claim 14, wherein the multiple batteries (210) of the battery system (110) have two or more different performance specifications (568) among the multiple batteries (210) that differ with respect to a battery chemistry category (568) and/or the performance parameter (534); and
wherein the performance parameter (534) includes one or more of: a stored energy (570), an energy storage capacity (572), an electrical voltage (574), an electrical current (576), an electrical power (578).
